Europäisches Patentamt

European Patent Office

Office européen des brevets

(11) Veröffentlichungsnummer: **0 319 778 B1**

(19)

# EUROPÄISCHE PATENTSCHRIFT

(12)

(45) Veröffentlichungstag der Patentschrift: **15.07.92**

(51) Int. Cl.5: **H03M 9/00**, H03K 23/66

(21) Anmeldenummer: **88119520.0**

(22) Anmeldetag: **24.11.88**

(54) Anordnung zum Empfang von Daten.

(30) Priorität: **05.12.87 DE 3741252**

(43) Veröffentlichungstag der Anmeldung:
**14.06.89 Patentblatt 89/24**

(45) Bekanntmachung des Hinweises auf die
Patenterteilung:
**15.07.92 Patentblatt 92/29**

(84) Benannte Vertragsstaaten:
**AT CH DE ES FR GB IT LI SE**

(56) Entgegenhaltungen:

SPECIFICATIONS OF THE RADIO DATA SY-
STEM RDS FOR VHF/FM SOUND BROADCA-
STING, Tech. 3244 - E, März 1984, Seiten 3-31,
European Broadcasting Union, Brussel, BE

PROCEEDINGS OF THE IEE, Band 113, Nr. 2,
Februar 1966, Seiten 271-276, Stevenage, GB;
L. MAXWELL et al.: "Synthesis of counters
with any kind of feedback"

ELEKTRONIK, Band 31, Nr. 22, November
1982, Seiten 111-112, München, DE; H. VAHL-
DIEK: "Digitalisierung mit muP als Frequenzzähler"

Valvo GmbH, Hamburg
"Schaltungssammlung", Heft 2, Ausgabe
Juni 1972, Schaltung Nr. 137

R. Jourdain, "Programmer's Problem Solver
for the IBM PC, XT & AT", Prentice Hall
Press, New York, 1986, Seite 262

EBU-Review-Technical no. 204, April 1984,
Seiten 50-58, Brüssel, BE, S.R. Ely et al.:
"Design Principles for VHF/FM radio receivers using the EBU radio-data system RDS.

(73) Patentinhaber: **Blaupunkt-Werke GmbH**
**Robert-Bosch-Strasse 200**
**W-3200 Hildesheim(DE)**

(72) Erfinder: **Poschen, Dieter**
**Sedanstrasse 32**
**W-3200 Hildesheim(DE)**

(74) Vertreter: **Eilers, Norbert, Dipl.-Phys.**
**Blaupunkt-Werke GmbH Robert-**
**Bosch-Strasse 200**
**W-3200 Hildesheim(DE)**

EP 0 319 778 B1

**Beschreibung**

Die Erfindung geht aus von einer Anordnung nach der Gattung des Hauptanspruchs.

Unter der Bezeichnung Radio-Datensystem (RDS) ist ein System bekannt geworden, das eine Übertragung von Zusatzinformationen ermöglicht. So wird beispielsweise der Name des Programms übertragen und auf einer Anzeigevorrichtung im Empfänger sichtbar gemacht. Die Übertragung der Daten, welche die Zusatzinformationen umfassen, erfolgt mit einem Hilfsträger von 57 KHz. Die Daten werden dabei als digitale Signale übertragen, wobei vier Datenworte mit jeweils 26 Bits zu einer Gruppe zusammengefaßt sind.

Beim Empfang dieser zusätzlichen Daten ist eine Umsetzung in die Block- und Gruppenstruktur bzw. eine Serien-Parallel-Wandlung erforderlich. Hierzu werden ein Zähler, der in jeweils einem Datenwort die Stellen (bzw. Bits) zählt, und ein weiterer Zähler, der die Datenworte innerhalb der Gruppe zählt, benötigt. Solche Zähler sind im Prinzip aus der Valvo-Schaltungssammlung, Heft 2, Juni 1972, Schaltungsbeispiel Nr. 137, für die Zeitzählung in einer Digitaluhr in TTL-Technik bekannt, bei der in gesonderten Zählern Stundenzehner, Stundeneiner, Minutenzehner und Minuteneiner gezählt werden. Die erfindungsgemäße Anordnung hat den Vorteil, daß eine Zählung der Bits innerhalb der Datenworte und eine Zählung der Datenworte innerhalb der Gruppen in äußerst einfacher Weise möglich ist. Dabei kann die Erfindung mit Hilfe eines Mikrocomputers verwirklicht werden, wobei durch die Erfindung Rechenzeit gespart wird. Es ist jedoch auch eine Verwirklichung der Erfindung mit Hilfe von Zählerschaltungen möglich, wobei sich ein geringer Schaltungsaufwand durch die Erfindung ergibt.

Ausführungsbeispiele der Erfindung sind in der Zeichnung anhand mehrerer Figuren dargestellt und in der nachfolgenden Beschreibung näher erläutet. Es zeigt:

Fig. 1 eine Tabelle zur Darstellung des Unterschiedes zwischen einem Binärzähler und einem BCD-Zähler,

Fig. 2 ein Flußdiagramm zur Erläuterung der Erfindung,

Fig. 3 eine Code-Tabelle des in der erfindungsgemäßen Anordnung verwendeten Zählers und

Fig. 4 ein Blockschaltbild eines solchen Zählers.

Sowohl ein Binär- als auch ein BCD-Zähler besteht aus einzelnen Speicherplätzen für jeweils ein Bit. Bei dem Binärzähler wird beim Überlauf jeweils eines Speichers bzw. einer Stelle im mathematischen Sinn die nächsthöhere Stelle um 1 inkrementiert. Die jeweils im Zähler gespeicherte Information entspricht dem jeweiligen Zählergebnis, das im Dualzahlensystem dargestellt ist. Beim BCD-Zähler dagegen werden jeweils vier Binärstellen zu einer Dezimalstelle zusammengefaßt. Erreicht der Inhalt einer solchen Vierergruppe den Wert 1010, wird der Inhalt auf 0000 gesetzt, was durch Addieren von 6 geschehen kann, und die nächsthöhere Dezimalstelle wird um 1 inkrementiert.

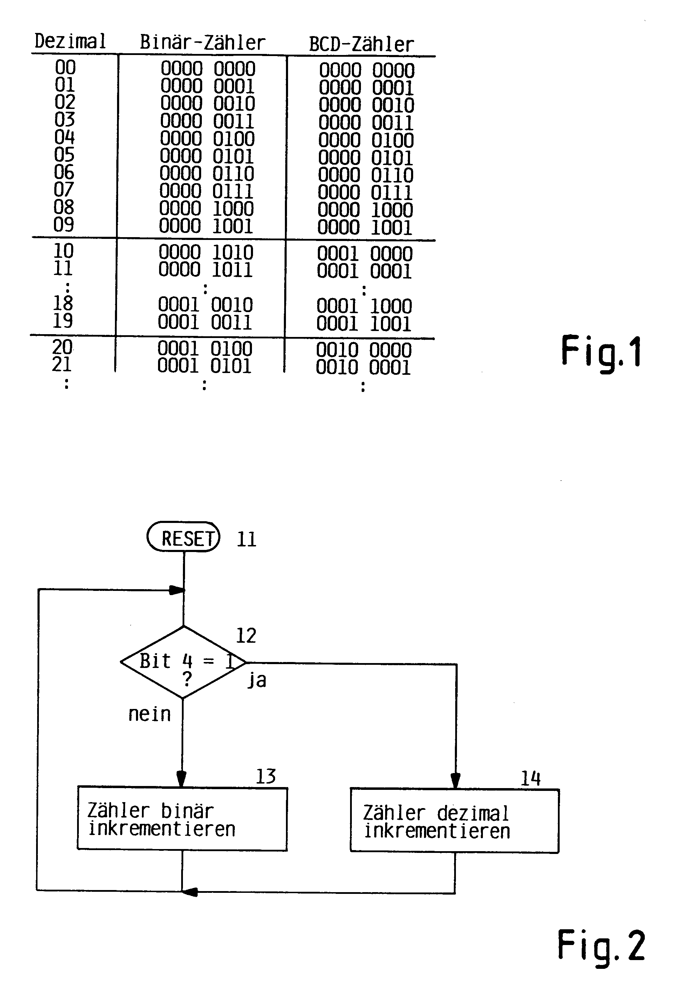

Bei der erfindungsgemäßen Anordnung ist ein Zähler vorgesehen, der acht Stellen aufweist und wahlweise als Binärzähler oder als BCD-Zähler inkrementiert werden kann. Dabei kann der Zähler durch einen Mikrocomputer mit einem entsprechenden Speicher oder durch eine an sich bekannte Zählschaltung gebildet sein. Das für den Mikrocomputer vorgesehene Programm ist in Fig. 2 schematisch als Flußdiagramm dargestellt. Beim Start 11 des Programms wird der Zähler zurückgesetzt, wonach eine Programmverzweigung 12 in Abhängigkeit davon erfolgt, ob das Bit 4 gleich 1 ist. Bei der Numerierung der Stellen bzw. Bits wird mit dem geringstwertigen Bit (LSB) als Bit 0 begonnen. Das Bit 4 ist also demnach das fünfte Bit von rechts bzw. das geringstwertige Bit der Zehnerdezimale.

Nach dem Start des Programms bei 11 ist dieses Bit gleich 0, so daß auf die Programmverzweigung 12 der Programmschritt 13 folgt, bei welchem der Zähler binär inkrementiert wird. Die Programmschritte 12 und 13 wiederholen sich solange, bis das Bit 4 gleich 1 ist. Dann wird der Zähler bei 14 dezimal inkrementiert, was wiederum solange durchgeführt wird, bis das Bit 4 wieder gleich 0 ist.

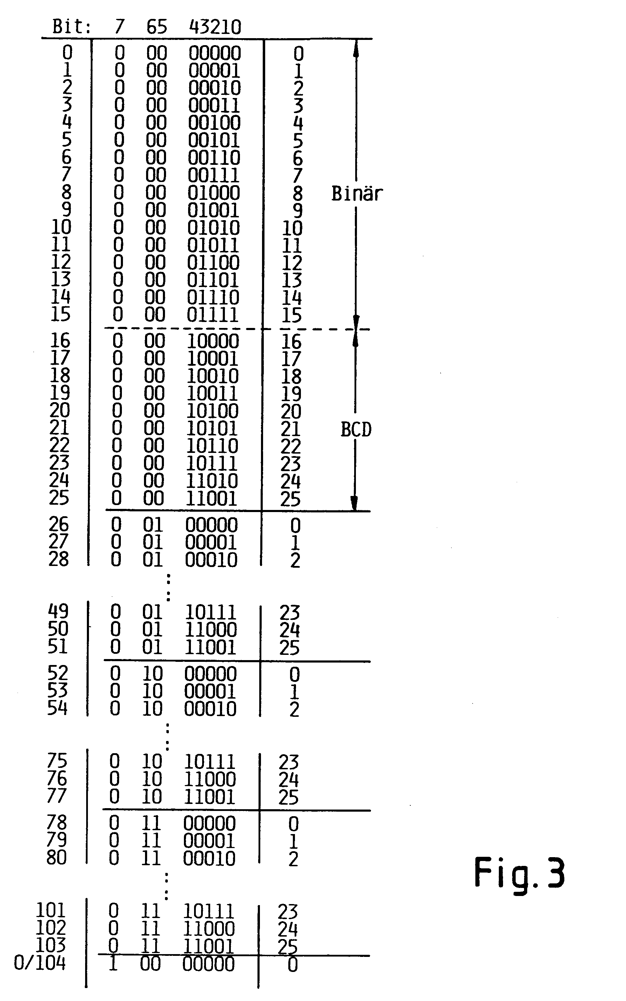

Das Ergebnis des Programmablaufs gemäß Fig. 2 ist in Fig. 3 tabellarisch dargestellt. Dabei sind die einzelnen Stellen des Zählers bereits in Gruppen zusammengefaßt, welche die Struktur der Gruppen bzw. Datenblöcke des RDS-Signals wiedergeben. Bit 4 ist jeweils unterstrichen, da es bei dem Programm nach Fig. 2 zur Entscheidung zwischen einer binären oder einer BCD-Zählung dient. Im Zahlenbereich von 0 bis 15 erfolgt eine binäre Zählung. Hat der Zähler jedoch 16 erreicht, erhält Bit 4 den Wert 1, wodurch die vier geringstwertigen Stellen des Zählers auf 0 gesetzt werden, worauf eine BCD-Zählung bis zum Wert 25 erfolgt. Dieser Wechsel zwischen binärer und BCD-Zählung findet wiederholt statt, bis bei dem Zählerstand 104 Bit 7 den Wert 1 annimmt und der Zählvorgang von vorn beginnt. Die Bits 0 bis 4 geben dabei die Position jeweils eines Bits innerhalb des Datenblocks wieder, während die Bits 5 und 6 die Datenblöcke innerhalb einer Gruppe kennzeichnen. Das Bit 7 schließlich kennzeichnet das Ende der Gruppe bzw. den Anfang einer neuen Gruppe.

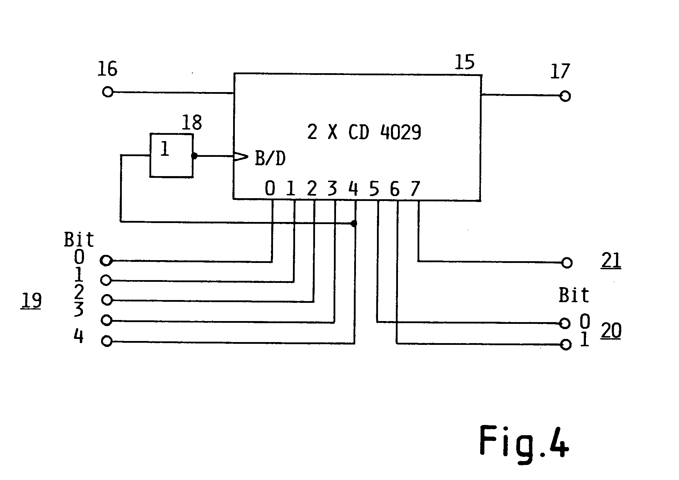

Fig. 4 zeigt eine erfindungsgemäße Anordnung, die mit an sich bekannten Bausteinen, beispielsweise vom Typ CD 4029, aufgebaut ist. An den Ausgängen 0 bis 7 der Zählschaltung 15 stehen die entsprechend bezeichneten Bits, die das Zählerergebnis verkörpern, an. Einem Eingang 16 wird das aus dem empfangenen RDS-Signal gewonnene Taktsignal T zugeführt. Außerdem wird beim Einschalten über einen weiteren Eingang 17 ein Rücksetzsignal zugeführt. Das Bit 4 wird vom Ausgang 4 über eine Invertierschaltung 18 einem Eingang B/D der Zählschaltung 15 zugeführt, welcher ein Umschalten zwischen einem Binärzähler und einem BCD-Zähler ermöglicht.

An einem fünf Bit breiten Ausgang 19 ist die Position des jeweils empfangenen Bits innerhalb eines Datenblocks abnehmbar. Am zwei Bit breiten Ausgang 20 steht die Position des jeweiligen Datenblocks innerhalb einer Gruppe an, während der Ausgang 21 ein Signal führt, welches das Ende einer Gruppe kennzeichnet.

## Patentansprüche

1. Anordnung zur Umsetzung der seriell empfangenen Daten im RDS-System in eine parallele Blockstruktur, wobei ein Datenblock jeweils 26 Bit aufweist und 4 Datenblöcke eine Gruppe bilden, die der Übertragung einer Informationseinheit dient,
gekennzeichnet durch,
einen derart geschalteten 8stelligen Binärzähler, daß die fünf geringstwertigen Stellen des Binärzählers als Modulo-26-Zähler und zwei weiteren Binärstellen als Modulo-4-Zähler betrieben werden, daß die Position des jeweiligen Datenblocks innerhalb der Gruppe am Ausgang des Modulo-4-Zählers und das Ende der Gruppe am Ausgang der höchstwertigsten Stelle abnehmbar ist und daß eine Inkrementierung des Zählerstandes als Binärzähler oder als BCD-Zähler in Abhängigkeit vom Wert der fünft geringstwertigen Binärstelle vorgenommen wird.

## Claims

1. Arrangement for converting the serially received data in the RDS system into a parallel block structure, one data block exhibiting in each case 26 bits and four data blocks forming a group which is used for transmitting an information unit, characterised by an 8-digit binary counter which is connected in such a manner that the five least-significant digits of the binary counter are operated as a modulo-26 counter and two further binary digits are operated as a modulo-4 counter, such that the position of the respective data block within the group can be picked up at the output of the modulo-4 counter and the end of the group can be picked up at the output of the most-significant digit and such that the count is incremented as a binary counter or as a BCD counter depending on the value of the fifth least-significant binary digit.

## Revendications

1. Montage pour convertir des données de réception de type série dans un système SDR en une structure par bloc parallèle, un bloc de données ayant chaque fois 26 bits et quatre blocs de données formant un groupe servant à la transmission d'une unité d'informations, caractérisé par
   - un compteur binaire à huit positions commuté de façon à mettre en oeuvre les cinq positions de niveau inférieur du compteur binaire pour fonctionner comme un compteur modulo (26) et deux autres positions binaires pour fonctionner comme un compteur modulo (4),
   - la position du bloc de données respectif dans le groupe, à la sortie du compteur modulo (4) et la fin du groupe étant disponibles à la sortie de la position de valeur supérieure
   - et une incrémentation de l'état de comptage comme compteur binaire ou compteur BCD se fait en fonction de la valeur des cinq positions binaires les plus faibles.

| Dezimal | Binär-Zähler | BCD-Zähler |
|---|---|---|
| 00 | 0000 0000 | 0000 0000 |
| 01 | 0000 0001 | 0000 0001 |
| 02 | 0000 0010 | 0000 0010 |
| 03 | 0000 0011 | 0000 0011 |
| 04 | 0000 0100 | 0000 0100 |
| 05 | 0000 0101 | 0000 0101 |
| 06 | 0000 0110 | 0000 0110 |
| 07 | 0000 0111 | 0000 0111 |
| 08 | 0000 1000 | 0000 1000 |
| 09 | 0000 1001 | 0000 1001 |
| 10 | 0000 1010 | 0001 0000 |
| 11 | 0000 1011 | 0001 0001 |
| ⋮ | ⋮ | ⋮ |
| 18 | 0001 0010 | 0001 1000 |
| 19 | 0001 0011 | 0001 1001 |
| 20 | 0001 0100 | 0010 0000 |
| 21 | 0001 0101 | 0010 0001 |
| ⋮ | ⋮ | ⋮ |

# Fig.1

Fig.2

RESET 11

Bit 4 = 1 ? 12

nein

ja

Zähler binär inkrementieren 13

Zähler dezimal inkrementieren 14

| Bit: | 7 | 65 | 43210 | | |
|---|---|---|---|---|---|
| 0 | 0 | 00 | 00000 | 0 | |
| 1 | 0 | 00 | 00001 | 1 | |
| 2 | 0 | 00 | 00010 | 2 | |
| 3 | 0 | 00 | 00011 | 3 | |
| 4 | 0 | 00 | 00100 | 4 | |
| 5 | 0 | 00 | 00101 | 5 | |
| 6 | 0 | 00 | 00110 | 6 | |
| 7 | 0 | 00 | 00111 | 7 | |
| 8 | 0 | 00 | 01000 | 8 | Binär |
| 9 | 0 | 00 | 01001 | 9 | |
| 10 | 0 | 00 | 01010 | 10 | |
| 11 | 0 | 00 | 01011 | 11 | |
| 12 | 0 | 00 | 01100 | 12 | |
| 13 | 0 | 00 | 01101 | 13 | |
| 14 | 0 | 00 | 01110 | 14 | |
| 15 | 0 | 00 | 01111 | 15 | |
| 16 | 0 | 00 | 10000 | 16 | |
| 17 | 0 | 00 | 10001 | 17 | |
| 18 | 0 | 00 | 10010 | 18 | |
| 19 | 0 | 00 | 10011 | 19 | |
| 20 | 0 | 00 | 10100 | 20 | |
| 21 | 0 | 00 | 10101 | 21 | BCD |
| 22 | 0 | 00 | 10110 | 22 | |
| 23 | 0 | 00 | 10111 | 23 | |
| 24 | 0 | 00 | 11010 | 24 | |
| 25 | 0 | 00 | 11001 | 25 | |
| 26 | 0 | 01 | 00000 | 0 | |
| 27 | 0 | 01 | 00001 | 1 | |
| 28 | 0 | 01 | 00010 | 2 | |
| ⋮ | | | | | |
| 49 | 0 | 01 | 10111 | 23 | |
| 50 | 0 | 01 | 11000 | 24 | |
| 51 | 0 | 01 | 11001 | 25 | |
| 52 | 0 | 10 | 00000 | 0 | |
| 53 | 0 | 10 | 00001 | 1 | |
| 54 | 0 | 10 | 00010 | 2 | |
| ⋮ | | | | | |
| 75 | 0 | 10 | 10111 | 23 | |
| 76 | 0 | 10 | 11000 | 24 | |
| 77 | 0 | 10 | 11001 | 25 | |
| 78 | 0 | 11 | 00000 | 0 | |
| 79 | 0 | 11 | 00001 | 1 | |
| 80 | 0 | 11 | 00010 | 2 | |
| ⋮ | | | | | |
| 101 | 0 | 11 | 10111 | 23 | |
| 102 | 0 | 11 | 11000 | 24 | |
| 103 | 0 | 11 | 11001 | 25 | |
| 0/104 | 1 | 00 | 00000 | 0 | |

## Fig.3

Fig.4